Europäisches Patentamt

(19) European Patent Office

Office européen des brevets

(11) Publication number: **0 051 081**

**A1**

(12) # EUROPEAN PATENT APPLICATION

(21) Application number: **80106729.9**

(22) Date of filing: **03.11.80**

(51) Int. Cl.³: **G 03 C 5/34**
**G 03 F 7/08, B 41 N 1/08**

(43) Date of publication of application:
**12.05.82  Bulletin  82/19**

(84) Designated Contracting States:
**BE DE FR GB NL**

(71) Applicant: **Fromson, Howard A.**
**15 Rogues Ridge Road**
**Weston Connecticut 06880(US)**

(72) Inventor: **Fromson, Howard A.**
**15 Rogues Ridge Road**
**Weston Connecticut 06880(US)**

(72) Inventor: **Gracia, Robert F.**
**451 First Parish Road**
**Scituate Massachusetts 02066(US)**

(74) Representative: **Schulze Horn, Stefan, Dipl.-Ing. et al,**
**Goldstrasse 36**
**D-4400 Münster(DE)**

(54) **Lithographic developing process and apparatus.**

(57) Process for developing a lithographic printing plate having a hydrophilic, anionic, negatively charged surface and a layer of a light sensitive, cationic material which has been selectively exposed to actinic light in an image area. The plate is contacted after exposure with an aqueous developing solution of an anionic material. The anionic material is capable of ionically coupling with unexposed light sensitive material and of dissolving the coupled product.

EP 0 051 081 A1

## Background

This invention relates to a lithographic developing process and apparatus.

Lithographic printing techniques, using, for example, anodized and silicated aluminum base plates such as described in Fromson patent No. 3,181,641 issued May 4, 1965, have come into widespread use in the printing industry and especially in offset printing and direct lithographic printing by newspapers using converted letterpress printing presses.

A conventional negative working lithographic printing plate of this type has a coating of a light sensitive substance that is adherent to the aluminum base sheet for exposure. If the light sensitive coating is applied to the base sheet by the manufacturer, the sheet is referred to as a "presensitized plate". If the light sensitive substance is applied to the base by the lithographer or trade plate maker, the plate is referred to as a "wipe-on plate". Depending on the nature of the photosensitive coating employed, a coated plate may be utilized to reproduce directly the image to which it is exposed, in which case it is termed a positive-acting plate, or to produce an image complementary to the one to which it is exposed, in which case it is termed a negative acting plate. In either case, the image area of the developed plate is oleophilic and the non-image area is hydrophilic.

In the case of negative working plate, the surface is coated with an aqueous solution of a conventional diazo resin. The plate is dried and exposed through a negative. The exposed image areas become water insoluble and the unexposed non-image areas remain water soluble. The plate is conventionally developed with a lithographic lacquer which consists of a two-phase system, one phase containing an oleophilic resin in a solvent and the other phase a hydrophilic gum. Upon application, the oleophilic resin adheres to the exposed insoluble areas, while the hydrophilic phase dissolves away most of the unexposed still soluble non-image areas. The gum in the hydrophilic phase covers the background and prevents ink pick-up in the background that is caused by residual diazo that is not dissolved away. In this way, the image areas are made oleophilic or ink receptive and the non-image areas are made hydrophilic or ink repellent.

In conventional developing systems, a solvent, such as water or an organic liquid, is used to selectively remove portions of the light sensitive coating that remain soluble after exposure to actinic light. However, because there is a certain affinity between the lithographic substrate and the light sensitive coating which is not overcome by the dissolving power of the solvent, some light sensitive coating will undesirably remain in the area that should be free of this material for proper lithographic printing.

In the case of an anodized aluminum substrate, which is one of the most widely used substrates in lithographic printing, treatments are employed to render the surface hydrophilic. Silicating as described in U. S. 3,181,461 is widely used. This creates an anionic, negatively charged surface. When a cationic light sensitive material is used such as a diazo, the resulting ionic affinity simply cannot be overcome by a solvent action. The residual diazo in the background creates real problems and must be masked with gum arabic before the plate will print correctly. Because the gum can wear off quickly, plates often scum after a short run on the press. The fact that residual diazo remains in the background can be demonstrated by reexposing a plate after development using a different negative. Development a second time produce an image in the background which indicates that not all of the diazo was removed in the first exposure-developing operation.

The present invention provides a developing system using an aqueous developer that removes the soluble light sensitive material completely. The invention also overcomes ecological problems by providing an aqueous system which can replace heretofore used organic solvent systems.

## SUMMARY

The process of the invention is for developing a lithographic printing plate having a substrate having a hydrophilic anionic, negatively charged surface and a layer on said surface of a light sensitive, cationic material which has been selectively exposed to actinic light in an image area. The process is carried out by contacting the plate after exposure which a developer consisting essentially of an aqueous solution of an anionic material. The anionic material functions in two ways. First it ionically couples (chemically reacts) with unexposed light sensitive material and secondly, it dissolves the coupled product. The coupling reaction overcomes the affinity of the light sensitive material for the substrate and the ability of the anionic material to dissolve the coupled product insures substantially complete removal of unexposed material leaving a hydrophilic non-image area. Thus the aqueous developer has a concentration of anionic material that is sufficient to couple whith the unexposed material and also dissolve the coupled product. A plate developed according to the invention shows no second image in the background upon reexposure indicating substantially complete removal from the unexposed areas.

## DESCRIPTION OF THE DRAWING

The accompanying drawing is a schematic figure of the apparatus of the invention for developing lithographic plates.

DESCRIPTION

Ionic development of diazonium light sensitive compounds depends on a chemical reaction between the positively charged (cationic) diazonium resin and a negatively charged (anionic) chemical entity in an ionizing medium such as water or water miscible compounds. Upon formation, the reaction product precipitates and if and when the concentration of the anionic compound in the ionizing medium is high enough, instant redissolution of the reaction product occurs. In this way the reaction product is prevented from reprecipitating on the surface from which it was removed.

The determining variables in formulating a suitable developer are:

1. The anionic material
2. The cationic diazonium compound
3. Relative concentrations of both cationic diazonium and the anion.
4. The volume of the developing colution and its diffusion properties.
5. The temperature, which affects the rate of reaction.
6. The pH
7. Macro physical agitation, which affects the micro chemical diffusion by renewing surfaces and homogenizing reaction gradients.

Suitable anionic materials are water soluble and include the alkali metal salts of alkylaryl sulfonates having 1 to 20 carbon atoms in the alkyl portion and 6 to 14 carbon atoms in the aryl portion, alkali metal salts of alkyl sulfonates having 12 to 20 carbon atoms and ammonium and alkali metal salts of sulfated higher fatty alcohols having 10 to 20 carbon atoms. Anionic materials used in the invention are usually dissolved in water and the concentration of the anionic material is sufficient to form an ionically coupled product with the light sensitive material and to dissolve the coupled product.

In more practical terms, it has been found that concentrations of anionic material of from 1 to 100 % function satisfactorily with diazo materials coated on a substrate form solutions having a concentration of from 0.01 to 5 %.

The rate of developing can also be accelerated by heating the developer to a temperature in the range of from 18 to 90° C, preferably from 22 to 60° C.

Specific examples of anionic materials are given herein together with a test to determine suitability. The effectiveness of certain anionic surfactants can be improved by adjusting the pH or by using a water miscible co-solvent such as an alkyl alcohol containing 1 - 8 carbon atoms or a glycol.

While a pH adjuster or co-solvent can be present, the presence of other materials such as cationic materials that will interfere with or prevent the coupling reaction between the cationic light sensitive and anionic materials in the non-image areas and subsequent dissolution of the coupled material in the non-image areas, must be avoided.

Cationic dyes can be applied to the anionically charged substrate or incorporated in the light sensitive material to provide a visible image on the plate. Suitable dyes include basic cationic dyes such as Victoria Green, Rhodamine B, Rhodamine 5 GLD, Crystal Violet, extra pure APN, Paper Blue R and the like.

Cationic light sensitive materials used in the invention include diazonium materials and have reactive sites capable of coupling with an anionic material. For example, diphenylamine condensed with a carbonyl compound such as formaldehyde has the required reactive sites.

Preferred are water soluble diazonium compounds but water insoluble compounds can also be used. Suitable diazonium compounds are described in U. S. 3,849,392 to Steppan and U. S. 3,311,605 to Steppan.

Diazonium molecules are very strong cations and react instaneously with materials of the opposite charge, namely, anionic materials such as surfactants, dyes, polymers and the like. Thus, when an unexposed diazonium material is treated with an aqueous anionic material such as sodium lauryl sulfate, a coupling reaction between diazonium material and the anionic material takes place. It is thus believed that there is a two-step sequence, first the coupling reaction between the diazonium material and an anionic material in the aqueous developer followed by dissolution of the coupled material from the background by the developer containing sufficient excess anionic material (after the coupling reaction) for the dissolution.

The hydrophilic, anionic negatively charged lithographic substrate can be a single sheet or a laminate and can be rigid or flexible. The substrate may be coated paper, a plastic film or sheet or a metallic sheet each treated to render the surface hydrophilic and anionically charged. The preffered lithographic substrate is anodized aluminum which may be pretreated before anodizing to roughen or grain the surface, for example using mechanical, chemical or electro-chemical techniques as are well known in the art and it may be post-treated after anodizing. It is preferred to impart hydrophilicity and anionic charge by silicating as described in Fromson patent No. 3,181,461.

·After treatment with the anionic material, the image can be reinforced with an oleophilic UV curable material which can be coated on and then cured. This is described in copending application Serial No. 972,567, filed December 22, 1978, which is incorporated herein by way of reference.

Suitable UV curable materials are commercially available from a number of sources in the form of UV curable inks, coating, oligomers and monomers. Such commercially available materials can be obtained from the following companies:
Inmont Corporation, Sinclair & Valentine, Celanese Chemical Company, 3-M Company, Desoto Chemical Company, Paulimer Industries, Shell Chemical, Mobile Chemical, W. R. Grace, Design Coat Company, and Ware Chemical Corporation.

UV curable materials including monomers and oligomers are described in the following patents:

| U. S. 3,297,745 | 1967 |
| U. S. 3,380,381 | 1968 |
| U. S. 3,673,140 | 1972 |
| U. S. 3,770,643 | 1972 |
| U. S. 3,712,871 | 1973 |
| U. S. 3,804,736 | 1974. |

There are also materials that will cure upon exposure to other sources of radiation, for example an electron beam. These curable materials can be used in special applications in place of the UV material and are commercially available. Electron beam curable compositions are described in U. S. patents 3,586,526-30, 1971.

A test to determine whether a particular anionic material is suitable is as follows:

A 5 % aqueous solution of the anionic material is prepared. An aluminum lithographic plate grained, anodized, and silicated is coated with a 1 % solution of a light sensitive diazo condensation product (such as Fairmont's Chemical Diazo # 4). The coated plate is exposed through a negative for a relatively short period of time 5 to 10 seconds. The exposed plate is immersed in the 5 % solution of anionic material for 10 seconds. The plate is then rinsed thoroughly with water and dried. The plate is then turned ninety degrees and exposed a second time through the same negative. The twice exposed plate is then lacquered with a standard lithographic lacquer (such as Fairmont's Black Lacquer). If only a single image appears, the anionic material is suitable. If a double, crossed image appears, diazo is being left in the background of the first image which means the material is not suitable.

The effectiveness of certain anionic materials can be enhanced by either a pH adjustment and/or the use of a water miscible co-solvent. The optimum pH for most anionic materials useful in this invention is in the range of pH 2 - 10. Suitable co-solvents are alcohols such as ethanol, butanol and the like and glycols.

Many different salts of anionic materials are suitable; these include sodium, lithium, ammonium, or triethanol amine salts and the like. Examples of suitable anionic surfactants (and their commercial sources) are as follows:

1. Sodium lauryl sulfate (Procter & Gamble, Equex S. Equex SP; Alcolac, Inc. Sipex SB).

2. Ammonium lauryl sulfate (Alcolac, Inc., Sipon L-22).

3. Sodium lauryl ether sulfate (Alcolac, Inc., Sipon ES).

4. Sodium dodecyl benzene sulfonate (Alcolac, Inc. Siponate DS-XD).

5. Ammonium lauryl ether sulfonate (Alcolac, Inc. Sipon EA).

6. Triethanolamine lauryl sulfate (Alcolac, Inc. Sipon LT-6).

7. Sodium alkyl sulfate (Alcolac, Inc., Sipex OLS).

8. Sodium stearate (Emery Inds.).

9. Sodium palmitate (Emery Inds.).

10. Sodium oleate (Matlerson, Coleman & Bell).

11. Dioctyl sodium sulfosuccinate (Cyanamid, Aerosol OT).

12. Tetrasodium N-Cl, 2 dicarboxyethyl 1) - N - octadecyl sulfosuccinate (Cyanamid, Aerosol 22).

13. Sodium Xylene sulfonate (Witco Chemical, Ultra SXS).

14. Sodium toluene sulfonate (Witco Chemical, Ultra STS).

15. Sodium cumene sulfonate (Witco Chemical, Ultra SCS hydrotrope).

16. sodium dihexyl sulfosuccinate (Cyanamide Aerosol AY-65).

17. Sodium diamyl sulfosuccinate (Cyanamide Aerosol AY-65).

18. Anionic phosphate surfactant (Rohm & Haas Co., Triton QS-30).

19. Sodium alkylaryl polyether sulfate (Rehm & Haas Co., Triton W-30 conc.).

20. Phosphate surfactant, potassium salt (Rohm & Haas Co., Triton H-66).

21. Sodium alkylaryl polyether sulfonate (Rohm & Haas Co., Triton X-200).

Sodium lauryl sulfate is preferred because of its availability and cost.

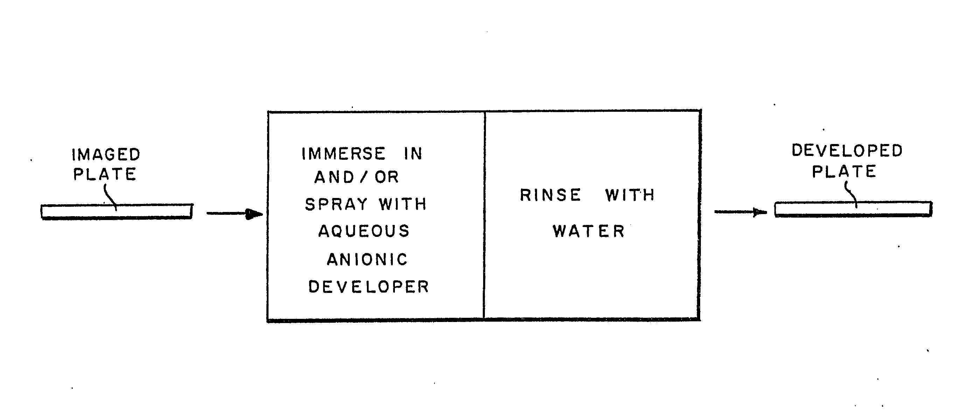

As shown in the drawing, an exposed plate is fed to a first station where it is immersed in and/or sprayed with the aqueous developer and then to a second station where it is rinsed with water.

A blanket exposure station can follow the second station as well as a UV coating and exposure station, as described herein.

EXAMPLE 1

A problem common to most lithographic plates coated with negative working condensation products of diazonium salts is failure to completely remove the unexposed diazo in nonimage areas. To illustrate: a brush grained, anodized, silicated plate is coated with a 3 % solution of a water soluble diazo resin (Fairmont's Diazo Resin # 4). The plate is exposed through a negative for 90 seconds with a Nu-arc fliptop unit to a solid 6 or 7 on a Stouffer Step Guide. After exposure the plate is immersed in running tap water, under yellow lights, for eight hours. The plate is then wiped, dried, and returned to the exposure unit. This time the negative is turned at right angle from the previously exposed image. The plate is reexposed for 90 seconds and developed using any available commercial developing lacquer. Upon development, it will be noted that two distinct image patterns exist on the plate. One from the first exposure and a seccond at right angles to the first.

EXAMPLE 2

A brush grained, anodized, silicated plate is coated and exposed as in Example 1. The plate is developed with a commercial developing lacquer such as Western's Jet Black or Fairmont's Black lacquer. After developing, rinsing, and drying, the plate is reexposed with the negative turned at 90°. The plate when inked all over results in a double image.

EXAMPLE 3

A plate is coated and exposed as in Example 1. The plate is immersed in a 5 % aqueous solution of sodium Lauryl sulfate for 10 seconds. The plate is then rinsed, dried, and reexposed as in Example 1. After the second exposure the plate is inked entirely, no second image results indicating that the background has been thorougly cleaned, leaving no residual diazo.

EXAMPLE 4

A brush grained, anodized, silicated plate is coated with a 1 % solution of diazo resin #4 (Fairmont Chemical Co.). The plate is exposed for 10 seconds on a Nu arc flip top exposure unit. The plate is developed by immersing it in a hot (50° C) solution (5 %) of sodium lauryl sulfate (SLS) for 2 seconds. The plate is rinsed, dried, and ready for press.

EXAMPLE 5

A plate is coated, exposed and processed as in Example 3, except that the developer is acidified by adding

13

2.5 cc/liter of phosphoric acid. The plate is exposed a second time with similar results.

EXAMPLE 6

Two plates are coated as in Example 1. The plates are then exposed for 10 seconds. One plate is developed by hand using a sponge and rubbing a 5 % solution of SLS vigorously over the entire plate surface. After development the plate is rinsed thoroughly and dried. The second plate is developed by immersing the plate completely in a 5 % solution of SLS for 10 seconds, rinsing and drying. Both plates are now tested for background cleanliness by applying either laquer or ink over the entire surface. This test should be repeated many times for statistical confimation. It will be noted that invariably hand developed plate or plates developed via the application of pressure to the surface be it scrubbing, rubbing, or buffing will have undesirable background or scumming marks. Plates processed via immersion will invariably have clean backgrounds.

EXAMPLE 7

Two plates are coated as in Example 1. These plates are exposed for 10 seconds and one plate is spray developed with a 5 % SLS and the other is developed by cascading SLS over the surface of the plate. In both instances clean, acceptable plates resulted.

WHAT IS CLAIMED IS:

1. Process for developing a lithographic printing plate comprising a substrate having a hydrophilic, anionic, negatively charged surface and a layer on said surface of a light sensitive, cationic material which has been selectively exposed to actinic light in an image area which comprises contacting the plate after exposure with a developer consisting essentially of an queous solution of an anionic material, said anionic material being capable of ionically coupling with unexposed light sensitive material and of dissolving the coupled product, said aqueous solution having a concentration of anionic material which is sufficient to couple with said unexposed material and dissolve the coupled product.

2. Process of claim 1 wherein the plate after exposure is immersed in the developer.

3. Process of claim 1 wherein the light sensitive material is a diazonium material.

4. Process of claim 1 wherein the developer is at a temperature of from 18 to 90° C.

5. Process of claim 1 wherein the anionic surfactant is selected from the group of alkali metal salts of alkylaryl sulfonates, alkali metal salts of alkyl sulfonates and alkali metal and ammonium salts of sulfated higher fatty alcohols.

6. Apparatus for developing a lithographic printing plate comprising a substrate having a hydrophilic, anionic negatively charged surface and a layer on said surface of a light sensitive cationic material which has been selectively exposed to actinic light in an image area which comprises

(I)     means for contacting the plate after exposure with a developer consisting essentially of an aqueous solution of an anionic material said anionic material being capable of ionically coupling with unexposed light sensitive material and of dissolving the coupled product, said aqueous solution having a concentration of anionic material which is sufficient to couple with said unexposed material and dissolve the coupled product.

(II)    means following the contacting means for rinsing the plate.

7. Apparatus of claim 6 wherein the means for contacting includes means for immersing and/or spraying the plate with the developer.

IMAGED
PLATE

IMMERSE IN
AND/OR
SPRAY WITH
AQUEOUS
ANIONIC
DEVELOPER

RINSE WITH
WATER

DEVELOPED
PLATE

0051081

European Patent Office

**EUROPEAN SEARCH REPORT**

Application number

EP 80106729.9

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | US - A - 3 891 439 (LEON KATZ)<br><br>+ Totality +<br><br>---- | 1,3,5, | G 03 C  5/34<br>G 03 F  7/08<br>B 41 N  1/08 |

TECHNICAL FIELDS SEARCHED (Int. Cl.³)

G 03 C

G 03 F

B 41 N

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| X | The present search report has been drawn up for all claims |
|---|---|

| Place of search | Date of completion of the search | Examiner |
|---|---|---|
| VIENNA | 30-06-1981 | SALTEN |

EPO Form 1503.1  06.78